# EUROPEAN PATENT APPLICATION

(11) **EP 4 625 706 A1**
(43) Date of publication of application: **01.10.2025**
(21) Application number: 23894490.4
(22) Date of filing: 15.11.2023
(51) Int. Cl.: H01R 11/01, B23K 35/26, C22C 11/06, C22C 13/00, C22C 13/02, C22C 30/04, G06K 19/077, H01L 21/60

(54) **ANISOTROPIC CONDUCTIVE FILM, ELECTRONIC COMPONENT MANUFACTURING METHOD, AND CARD LAMINATED BODY**

(30) Priority: 24.11.2022 JP 2022187515; 14.11.2023 JP 2023193636
(71) Applicant: Dexerials Corporation, Shimotsuke-shi, Tochigi 323-0194 (JP)
(72) Inventor: ODAKA, Ryosuke, Shimotsuke-shi, Tochigi 323-0194 (JP); DATE, Kazuhiro, Shimotsuke-shi, Tochigi 323-0194 (JP); ABE, Tomoyuki, Shimotsuke-shi, Tochigi 323-0194 (JP)
(74) Representative: Hoffmann Eitle
(86) International application number: PCT/JP2023/041089
(87) International publication number: WO 2024/111481

(57) **Abstract**

A conductive particle-containing hot melt adhesive sheet 60 is an anisotropic conductive film used to bond an IC chip 10 to a base substrate 30, and contains a solder particle that is a non-eutectic alloy or an eutectic alloy, and a thermoplastic resin. The conductive particle-containing hot melt adhesive sheet 60 has an area ratio of the solder particle of 8 to 50% and a viscosity of the solder particle at the solidus temperature of 1,000 to 100,000 Pa•s.

## Description

### Field

The present invention relates to an anisotropic conductive film, a method for producing an electronic component, and a card laminate.

### Background

Examples of the method for mounting an IC chip to a smart card include the method that is disclosed in Patent Literature 1. In the method disclosed in Patent Literature 1, a hot melt adhesive sheet containing a conductive particle including a solder particle is interposed between a card member material and an IC chip, and then heat and pressure are applied to this sheet. The heat and pressure causes the solder particle included in the conductive particle-containing hot melt adhesive sheet to be melted, resulting in conductively bonding the conductive section in the IC chip side with the conductive section in the card member material side by a metallic bonding.

### Citation List

### Patent Literature

Patent Literature 1: Japanese Patent No. 6966659 Summary

### Technical Problem

For example, when a semiconductor component is bonded to a glass substrate using an anisotropic conductive film containing a conductive particle, a good or bad bonding of the conductive particle may be observed in the bonding section of the glass substrate by means of a microscope. However, when the IC chip is press-adhered to the card member material, the bonding section is not exposed because it is sandwiched between the opaque card member material and the opaque IC chip, making it difficult to externally observe by means of a microscope to judge whether melting of the solder particle is good or not.

In view of the above circumstances, an object of the present invention is to provide an anisotropic conductive film, a method for producing an electronic component, and a card laminate, in which a good or bad bonding may be observed nondestructively by a solder particle-containing anisotropic conductive film.

### Solution to Problem

To solve the above problem and achieve the objection, an anisotropic conductive film according to the present invention includes a solder particle that is a non-eutectic alloy or an eutectic alloy; and a thermoplastic resin, wherein an area ratio of the solder particle is 8 to 50%, and a viscosity of the solder particle at a solidus temperature is 1,000 to 100,000 Pa•s.

A method for producing an electronic component according to the present invention includes interposing an anisotropic conductive film that comprises a solder particle that is a non-eutectic alloy or an eutectic alloy, and a thermoplastic resin, has an area ratio of the solder particle of 8 to 50%, and has a viscosity of the solder particle at a solidus temperature of 1,000 to 100,000 Pa•s between an opaque first electronic component and an opaque second electronic component; and bonding the first electronic component and the second electronic component by hot press-bonding.

In the method for producing an electronic component, the electronic component may be a dual interface card.

In the method for producing an electronic component, the first electronic component may be a biometric sensor.

A card laminate according to the present invention includes a first electronic component; a second electronic component; a base substrate having the second electronic component disposed; and an anisotropic conductive film that comprises a solder particle that is a non-eutectic alloy or an eutectic alloy, and a thermoplastic resin, has an area ratio of the solder particle of 8 to 50%, and has a viscosity of the solder particle at a solidus temperature of 1,000 to 100,000 Pa•s, wherein the first electronic component and the second electronic component are bonded by the anisotropic conductive film.

In the card laminate, the first electronic component may be a biometric sensor.

### Advantageous Effects of Invention

The present invention allows nondestructive observation of a good or bad bonding by a solder particle-containing anisotropic conductive film.

### Brief Description of Drawings

FIG. 1 is a plan view to illustrate an example of the smart card.
FIG. 2 is a plan view of the back surface of the IC chip.
FIG. 3 is a schematic view of the cross section of the smart card.
FIG. 4 is a plan view of the IC chip area.
FIG. 5A is a drawing to illustrate the content of the preparation process.
FIG. 5B is a drawing to illustrate the content of the preparation process.
FIG. 5C is a drawing to illustrate the content of the preparation process.
FIG. 6A is a drawing to illustrate the content of the bonding process.
FIG. 6B is a drawing to illustrate the content of the bonding process.
FIG. 6C is a drawing to illustrate the content of the bonding process.
FIG. 7A is an X-ray photograph of the hot press-bonded section.
FIG. 7B is an X-ray photograph of the hot press-bonded section.
FIG. 7C is an X-ray photograph of the hot press-bonded section.
FIG. 8A is an X-ray photograph of the hot press-bonded section.
FIG. 8B is an X-ray photograph of the hot press-bonded section.
FIG. 8C is an X-ray photograph of the hot press-bonded section.

### Description of Embodiments

Hereinafter, the embodiments of the present invention will be described in detail with reference to the attached drawings. However, the present invention is not limited by the embodiments to be described below. In the descriptions in the drawings, identical or corresponding elements are marked with the same symbols as appropriate. Furthermore, it should be noted that the drawings are schematic so that, among other things, the relationship of the dimensions of each element may differ from the reality. Between the drawings, they may also contain portions that differ from each other in dimensional relationships and proportions.

### <1. Smart Card>

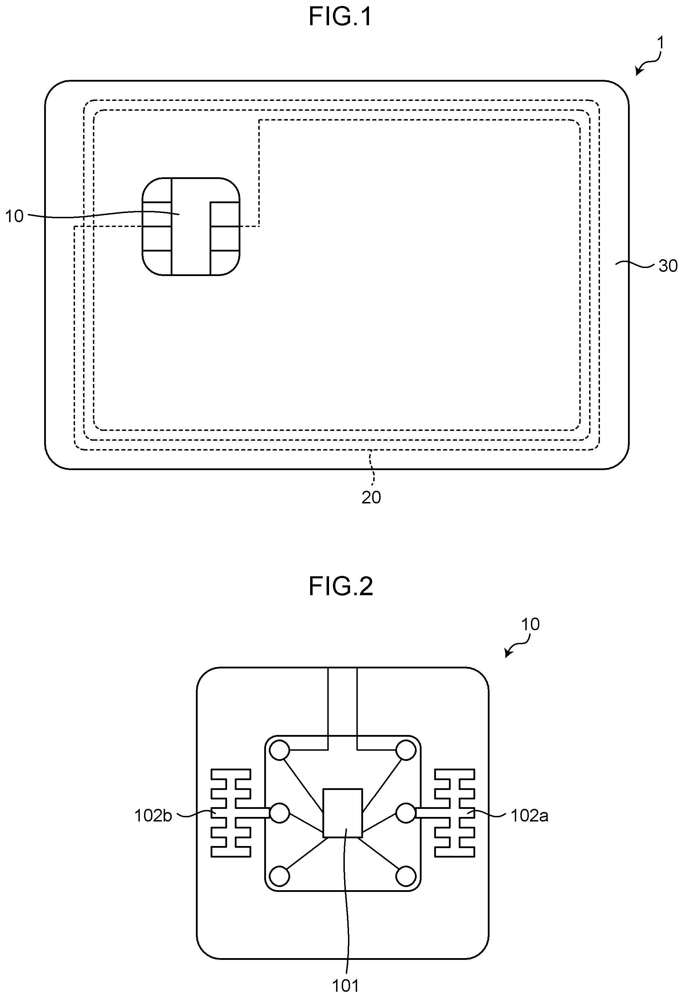

FIG. 1 is a plan view of a smart card 1 according to one example of the embodiment according to the present invention. The smart card 1 is, for example, a dual-interface card having one integrated circuit (IC) chip with two interfaces, a contact type and a noncontact type. The smart card 1 is one example of a card laminate. The smart card 1 is also called an "IC card" or a "chip card". The smart card 1 has an IC chip 10, an antenna 20, which is used for noncontact communication and for electromotive force generation, and a base substrate 30. The smart card 1 may be a hybrid card with a contact type IC chip and a noncontact type IC chip mounted thereon. The smart card 1 may also be a fingerprint authentication card mounted with a fingerprint sensor, which is one example of a biometric sensor, or a card having a function such as a one-time password function that incorporates a battery element and a display element. These IC chips, sensors, and elements are provided with a pad and are electrically bonded to the section that will become an electrode on the side of the base substrate 30.

The IC chip 10 is the chip having an integrated circuit for information (data) recording and calculation, and is one example of an opaque first electronic component. The IC chip 10 has on its surface a contact point with a reading terminal of the smart card 1. FIG. 2 is a plan view of the back surface of the IC chip 10, i.e., the side opposite the side having the contact point with the reading terminal. On the back surface of the IC chip 10, there is a molding section 101 that encapsulates an integrated circuit, and a first electrode section 102a and a second electrode section 102b that are electrically connected to the antenna 20.

The antenna 20 is a wiring that is arranged spirally and is used for communication by a radio wave with a noncontact type reading terminal. The antenna 20 is one example of a second electronic component. The antenna 20 generates an electric power by electromagnetic induction from the radio wave emitted from the noncontact type reading terminal and supplies the generated power to the IC chip 10.

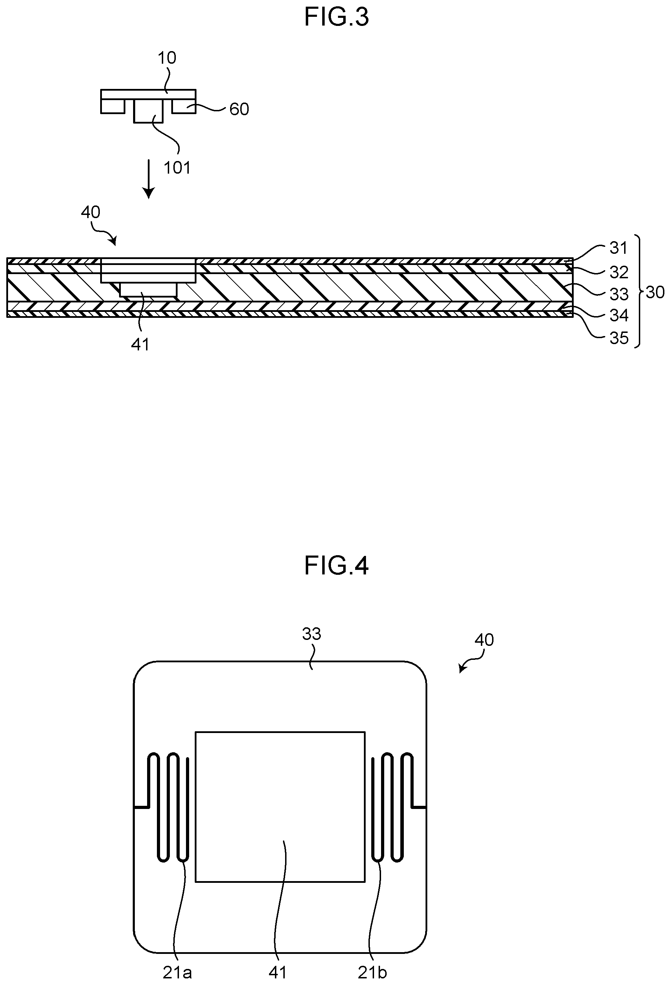

FIG. 3 is a schematic view of the cross section of the base substrate 30. The base substrate 30 is a laminate having an inlay 33 provided with the antenna 20, core sheets 32 and 34 laminated on both sides of the inlay 33, and overlays 31 and 35 that constitute the front and back surfaces of the smart card 1. The inlay 33, the core sheets 32 and 34, and the overlays 31 and 35 are formed of a resin material, for example. Illustrative examples of the resin material that constitutes the inlay 33, the core sheets 32 and 34, and the overlays 31 and 35 include polyvinyl chloride (PVC), polyethylene terephthalate (PET), PET-G, polycarbonate (PC), recycled materials of these resins, Ocean Plastics, and biodegradable plastics such as polylactic acid (PLA). The base substrate 30 is formed by laminating and integrating the inlay 33, the core sheets 32 and 34, and the overlays 31 and 35 by hot pressing with or without an intervening adhesive.

As for the adhesive that adheres the layers of the inlay 33, the core sheets 32 and 34, and the overlays 31 and 35, various materials including a thermoplastic material and a thermosetting material may be used. From the viewpoint of withstanding the cutting step of the base substrate 30 and the hot press-bonding step with the IC chip 10, a material having a resistance and a heat resistance to these processes are suitable. Among them, a thermosetting adhesive is suitably used.

The antenna 20 is formed in the inlay 33. An IC chip area 40 is formed in the base substrate 30 by cutting. The IC chip area 40 is the area where the IC chip 10 fits, in which part of the antenna 20 is exposed.

FIG. 4 is a plan view of the IC chip area 40. In the IC chip area 40, a first exposed section 21a and a second exposed section 21b, which are part of the pattern of the antenna 20, are exposed. The first exposed section 21a is electrically connected to the first electrode section 102a by a conductive particle-containing hot melt adhesive sheet 60, and the second exposed section 21b is electrically connected to the second electrode section 102b by the conductive particle-containing hot melt adhesive sheet 60. As for the wiring of the antenna 20, a copper wire is used, for example. From the viewpoint of securing a large overlapping area with the first and second electrode sections 102a and 102b, the pattern of the first and second exposed sections 21a and 21b is preferably a winding pattern as illustrated in FIG. 4. In the center of the IC chip area 40, an accommodation area 41 is formed by cutting so as to accommodate the molding section 101.

It is preferable that the inlay 33 has a unpenetrated groove or hole in the IC chip area 40 where the IC chip 10 fits. This allows the resin of the conductive particle-containing hot melt adhesive sheet 60 to flow into the groove or the hole, thereby improving the adhesion strength with the conductive particle-containing hot melt adhesive sheet 60. It is preferable that the shortest length of the opening of the groove or the hole is less than the average particle diameter of the solder particles. Specifically, the lower limit of the shortest length of the opening of the groove or the hole is preferably 20% or more, more preferably 30% or more, and especially preferably 40% or more of the average particle diameter of the solder particles. Specifically, the upper limit of the shortest length of the opening of the hole is preferably 80% or less, more preferably 70% or less, and especially preferably 60% or less of the average particle diameter of the solder particles. This makes easier for the solder particle to fit into the groove or hole, improving trapping of the solder particle and obtaining an excellent electrical connection with the IC chip 10.

The conductive particle-containing hot melt adhesive sheet 60 is interposed between the inlay 33 and the IC chip 10, and thereby electrically connecting the IC chip 10 to the first exposed section 12a and the second exposed section 12b of the antenna 20. The conductive particle-containing hot melt adhesive sheet 60 contains, for example, the solder particle that is a non-eutectic alloy, as the conductive particle in a binder containing a crystalline polyamide having a carboxyl group. In this specification, "the non-eutectic alloy" refers to an alloy that does not have an eutectic point. The conductive particle-containing hot melt adhesive sheet 60 is one example of the anisotropic conductive film (ACF). The solder particle included in the conductive particle-containing hot melt adhesive sheet 60 is not limited to the solder particle that is the non-eutectic alloy, but may also be the particle that includes the solder particle that is an eutectic alloy.

The smart card 1 according to this embodiment is provided with the conductive particle-containing hot melt adhesive sheet 60, which includes the solder particle that is the non-eutectic alloy in the binder containing the crystalline polyamide having a carboxyl group, thereby allowing to improve a solder wettability and to obtain excellent connection reliability and bending resistance. This is believed to be due to the fluxing effect of the carboxyl group present in the crystalline polyamide; because of this, the elastic modulus of the conductive particle-containing hot melt adhesive sheet 60 may be prevented from decreasing due to the addition of the fluxing compound, and whereby an excellent bending resistance may be obtained. In addition, because due to melting of the solder particle the smart card 1 according to this embodiment is bonded by a metallic bonding between the circuit (conductive section) of the IC chip 10 and the circuit (conductive section) of the antenna pattern, swelling and elongation due to moisture absorption of the binder in the wet heat test may be suppressed, thereby allowing to obtain an excellent connection reliability. This technology may also be applied to a general anisotropic bonding body. The scope of application of this technology is also similarly applied to the method for producing a bonding body.

### <2. Method for Producing Smart Card>

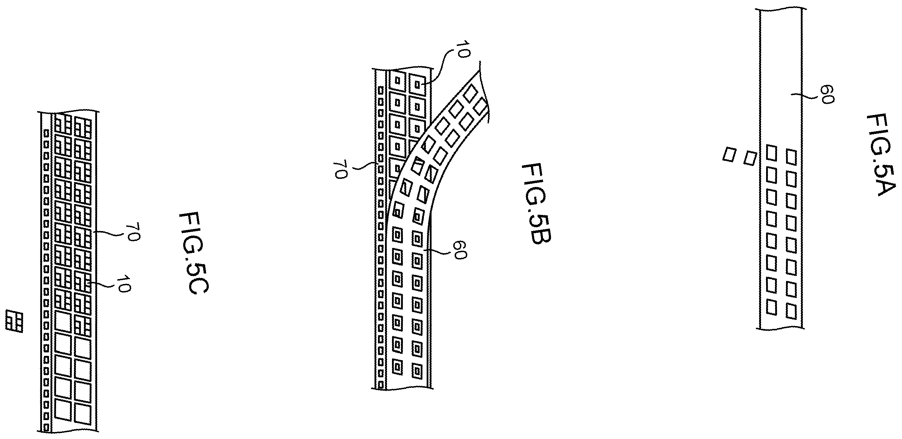

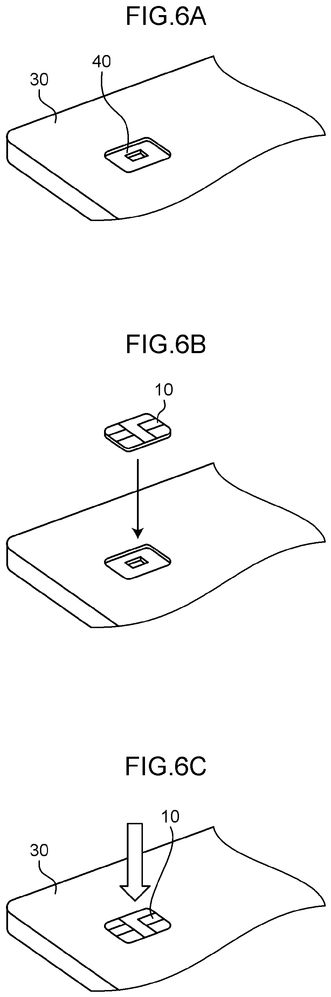

In the method for producing the smart card 1 according to this embodiment, the conductive particle-containing hot melt adhesive sheet 60 is interposed between the inlay 33 and the IC chip 10, which is then followed by the press bonding. Hereinafter, the production method of the smart card 1 will be described with referring to FIGS. 5A through 5C and FIGS. 6A through 6C. Roughly speaking, the production method of the smart card 1 is made up of a preparation process in which the IC chip 10 having the conductive particle-containing hot melt adhesive sheet 60 laminated thereto is produced, and a bonding process in which the IC chip 10 having the conductive particle-containing hot melt adhesive sheet 60 laminated thereto is press-bonded to the inlay 33.

### [Preparation Process]

FIGS. 5A through 5C illustrate the contents of the preparation process. The preparation process includes a sheet punching step, an attaching step, and an IC chip punching step. Hereinafter, the preparation process is described with referring to FIGS. 5A through 5C. In the preparation process, the sheet punching step is performed at first. The sheet punching step is the step at which the area corresponding to the shape of the molding section 101 in the tape-like conductive particle-containing hot melt adhesive sheet 60 is punched out, as illustrated in FIG. 5A. The conductive particle-containing hot melt adhesive sheet 60 is supplied, for example, as a film wound body that is wound around a winding core.

After the sheet punching step, the attaching step is performed. The attaching step is the step at which the conductive particle-containing hot melt adhesive sheet 60 is attached to the back surface of the IC chip 10. At the attaching step, for example, as illustrated in FIG. 5B, the conductive particle-containing hot melt adhesive sheet 60 is placed on the IC chip 10 kept on a carrier tape 70, and the conductive particle-containing hot melt adhesive sheet 60 is laminated to the bonding surface of the IC chip 10 by heating and pressing. Here, because the conductive particle-containing hot melt adhesive sheet 60 is punched out in the shape corresponding to the molding section 101, the conductive particle-containing hot melt adhesive sheet 60 contacts the first electrode section 102a and the second electrode section 102b; and the molding section 101 is exposed from the punched out area. The attaching step may be a temporary attaching step at which the conductive particle-containing hot melt adhesive sheet 60 is attached to the back surface of the IC chip 10 at a low temperature.

In the case that the attaching step is a laminating step, a pressurizing laminator or a vacuum pressurizing laminator may be used. When the attaching step is the laminating step, a relatively large area may be mounted all at once as compared to the temporary attaching step. In addition, in the case that the attaching step is the temporary attaching step, only minimal changes are required in tools for installation or modification from the previous equipment, thereby affording an economic advantage.

At the attaching step, the temperature to reach the conductive particle-containing hot melt adhesive sheet 60 is preferably equal to or above the temperature at which the binder flows and below the temperature at which the solder melts. The temperature at which the binder flows may be the temperature at which the melt viscosity of the conductive particle-containing hot melt adhesive sheet 60 becomes in the range of 100 to 100,000 Pa•s,or preferably in the range of 1000 to 100,000 Pa•s.This allows the conductive particle-containing hot melt adhesive sheet 60 to be attached to the back surface of the IC chip 10 while maintaining the shape of the solder particle. The melt viscosity of the conductive particle-containing hot melt adhesive sheet 60 may be measured, for example, by using a rotational rheometer (manufactured by TA instrument Inc.) under the following conditions: the measurement pressure of 5 g, the temperature range of 30 to 200°C with the temperature raising rate of 10°C/min, the measurement frequency of 10 Hz, the measurement plate diameter of 8 mm, and the load variation of 5 g to the measurement plate.

After the attaching step, the IC chip punching step is performed. At the IC chip punching step, as illustrated in FIG. 5C, the IC chip 10 to which the conductive particle-containing hot melt adhesive sheet 60 is attached is punched out from the carrier tape 70 to taken out the IC chip 10 from the carrier tape 70.

### [Bonding Process]

FIGS. 6A through 6C describe the contents of the bonding process. The IC chip 10 taken out from the carrier tape 70 in the preparation process is bonded to the base substrate 30 in the bonding process. The bonding process includes a counterboring step, a placing step, and a press-bonding step. Hereinafter, the bonding process will be described with referring to FIGS. 6A through 6C. In the bonding process, the counterboring step is performed at first. At the counterboring step, the IC chip area 40 is formed; and further the accommodation area 41, which accommodates the molding section 101, is formed by deep boring. With this counterboring step, the IC chip area 40 is formed as illustrated in FIG. 6A.

After the counterboring step, the placing step is performed. At the placing step, by using, for example, a tool equipped with a suction mechanism, the IC chip 10 is picked up, and the IC chip 10 is aligned with the IC chip area 40, and the IC chip 10 is placed in the IC chip area 40 with intervention of the conductive particle-containing hot melt adhesive sheet 60, as illustrated in FIG. 6B.

After the placing step, the press-bonding step is performed. At the press-bonding step, heat and pressure are applied to the IC chip 10 and the base substrate 30 using a press-bonding device to carry out the hot press-bonding of the IC chip 10 to the inlay 33, as illustrated in FIG. 6C. The number of times of the hot press-bonding in the press-bonding step may be set in accordance with the object to be bonded; it may be one time, but preferably multiple times. This prevents thermal deformation of the card from occurring, fully eliminates the binder of the conductive particle-containing hot melt adhesive sheet 60, and allows the solder particle to be melted thereby causing the metallic bonding of the first electrode section 102a to the first exposed section 21a and the second electrode section 102b to the second exposed section 21b to take place.

As for the hot press-bonding temperature at the press-bonding step, the temperature to reach the conductive particle-containing hot melt adhesive sheet 60 is preferably equal to or higher than the melting point of the solder particle . Here, the melting point refers to the solidus temperature. In other words, as for the hot press-bonding temperature at the press-bonding step, the temperature to reach the conductive particle-containing hot melt adhesive sheet 60 is preferably equal to or higher than the solidus temperature of the solder particle. Here, the solidus line is the curve expressing the relationship between the temperature of the liquid phase (melting point) in equilibrium with the solid phase and the composition of the solid phase. Specifically, the temperature to reach the conductive particle-containing hot melt adhesive sheet 60 is preferably in the range of 120 to 160°C, more preferably in the range of 120 to 155°C, and still more preferably in the range of 120 to 150°C. This suppresses a thermal shock to the base substrate 30 and the IC chip 10, and prevents deformation of the base substrate 30 from occurring.

The method for producing the smart card 1 according to this embodiment uses the conductive particle-containing hot melt adhesive sheet 60 containing a conductive particle including a solder particle in a binder containing crystalline polyamide having a carboxyl group, allowing to improve the solder wettability so as to obtain an excellent connection reliability. In addition, because the method for producing the smart card 1 according to this embodiment involves the metallic bonding of the conductive section of the IC chip 10 to the conductive section of the pattern of the antenna 20 by melting of the solder particle, swelling and elongation due to moisture absorption of the binder in the wet heat test may be suppressed, and whereby an excellent connection reliability may be obtained.

### <3. Conductive Particle-containing Hot Melt Adhesive Sheet>

The lower limit of the thickness of the conductive particle-containing hot melt adhesive sheet 60 is preferably 10 µm or more, more preferably 20 µm or more, and still more preferably 30 µm or more. The upper limit of the thickness of the conductive particle-containing hot melt adhesive sheet 60 is preferably 100 µm or less, more preferably 80 µm or less, and still more preferably 60 µm or less. This makes it suitable for use in the production of the smart card 1, in which the IC chip 10 is hot press-bonded to the base substrate 30.

The binder contains at least a crystalline polyamide having a carboxyl group. The crystalline resin may be recognized, for example, by observing an endothermic peak during the temperature raising process using a differential scanning calorimetry. The terminal carboxyl group concentration of the crystalline polyamide is preferably 0.5 mg KOH/g or more, more preferably 1.0 mg KOH/g or more, and still more preferably 2.0 mg KOH/g or more. The terminal carboxyl group concentration of the crystalline polyamide may be 50 mg KOH/g or less, 30 mg KOH/g or less, or 10 mg KOH/g or less. The terminal carboxyl group concentration of the crystalline polyamide may be evaluated according to, for example, JIS K 0070-1992 and ISO 2114. Examples of the commercially available crystalline polyamide having a carboxyl group include "HX2519" and "M1276", manufactured by Arkema S.A.

When the binder contains at least the crystalline polyamide having a carboxyl group, the solder wettability is improved, so that an excellent connection reliability may be obtained. This is believed to be due to the fluxing effect of the carboxyl group present in the crystalline polyamide; because of this, the elastic modulus of an adhesive layer 50 may be prevented from decreasing due to the addition of the fluxing compound, so that an excellent bending resistance may be obtained.

The binder may also contain other components as needed. Other components, such as a crystalline resin or an amorphous resin, may be selected as appropriate in accordance with the purpose. There is no particular restriction in the crystalline resin as long as it has a crystalline region. Illustrative examples thereof include a polyester resin, a polyolefin resin, and a polyurethane resin. Illustrative examples of the polyester resin include a polyethylene terephthalate resin and a polybutylene terephthalate resin; illustrative examples of the polyolefin resin include a polyethylene resin, a polypropylene resin, and a polybutylene resin. As for the amorphous resin, the same resins as those exemplified in the description of the crystalline resins may be cited. Among these, from the viewpoint of adhesion at a low temperature and for a short period, it is preferable that a crystalline polyester resin is included as the other component.

The ratio of the crystalline polyamide having a carboxyl groups in the binder is preferably in the range of 10 to 100% by weight, more preferably in the range of 30 to 100% by weight, and still more preferably in the range of 50 to 100% by weight. This improves the solder wettability thereby allowing to obtain an excellent connection reliability.

The solder particle included in the conductive particle-containing hot melt adhesive sheet 60 is a non-eutectic alloy or an eutectic alloy. When the non-eutectic alloy is used as the solder particle, this is preferably an alloy containing two or more metals selected from the group consisting of Sn, Bi, Ag, In, Cu, Sb, Pb, and Zn. The solder particle may be selected as appropriate from, for example, an Sn-Pb type, a Pb-Sn-Sb type, an Sn-Sb type, an Sn-Pb-Bi type, a Bi-Sn type, an Sn-Bi-Cu type, an Sn-Cu type, an Sn-Pb-Cu type, an Sn-In type, an Sn-Ag type, an Sn-Pb-Ag type, a Pb-Ag type, and the like, which are stipulated in JIS Z 3282-2017 (corresponding international standard: ISO 9453:2014), in accordance with the terminal material, the bonding condition, and the like.

The lower limit of the solidus temperature (melting point) of the solder particle is preferably 110°C or higher, more preferably 130°C or higher, and still more preferably 135°C or higher. The upper limit of the liquidus temperature of the solder particle may be 210°C or lower, preferably 200°C or lower, more preferably 195°C or lower, and still more preferably 190°C or lower. Here, the liquidus line is the curve expressing the relationship between the temperature of the liquid phase (melting point) in equilibrium with the solid phase and the composition of the liquid phase. The upper limit of the solidus temperature of the solder particle may be 155°C or lower, preferably 150°C or lower, more preferably 145°C or lower, and still more preferably 140°C or lower. The solder particle may also have a flux compound directly bonded to its surface in order to activate the surface. Activation of the surface promotes the metallic bonding to the metal wire and to the electrodes.

The solder particle desirably has the solidus temperature (melting point) of 155°C or lower, preferably 150°C or lower; and it is preferably at least one alloy selected from the group consisting of the Sn-Bi-Cu alloy, the Sn-Bi-Ag alloy, the Sn-Bi alloy, the Sn-Pb-Bi alloys, and the Sn-In alloy. Examples of the solder particle include specifically Sn30Bi0.5Cu, Sn30Bi, Sn40Bi, Sn50Bi, Sn58Bi, Sn40Bi0.1Cu, Sn43Pb14Bi, and Sn20In. With this, an excellent connection reliability may be obtained.

The solder particles may be dispersed by kneading in the resin in the conductive particle-containing hot melt adhesive sheet 60, or the solder particles may be arranged apart. This arrangement may be made in certain rules. Embodiments of the regular arrangement include lattice arrangements such as a square lattice, a hexagonal lattice, an orthorhombic lattice, and an oblong lattice. The solder particles may be arranged as an agglomerate of multiple solder particles. In this case, the arrangement of the agglomerates in the plan view of the conductive particle-containing hot melt adhesive sheet 60 may be a regular arrangement or a random arrangement, similar to the arrangements of the solder particles described above.

The average particle diameter of the solder particle is preferably 70% or more, more preferably 80% or more, and still more preferably 95% or more, relative to the thickness of the conductive particle-containing hot melt adhesive sheet 60. This allows the solder particles to be easily interposed between the conductive section of the IC chip 10 and the conductive section of the base substrate 30 during the hot press-bonding, allowing the metallic bonding to take place.

The lower limit of the average particle diameter of the solder particle is preferably 10 µm or more, more preferably 15 µm or more, and still more preferably 20 µm or more. The upper limit of the average particle diameter of the solder particle is preferably 50 µm or less, more preferably 45 µm or less, and still more preferably 40 µm or less. The maximum diameter of the solder particle may be made 200% or less, preferably 150% or less, and more preferably 120% or less, relative to the average particle diameter. When the maximum diameter of the solder particle is in the above-mentioned range, it is possible for the solder particle to be interposed between the conductive section of the IC chip 10 and the conductive section of the base substrate 30, so that the conductive sections may be bonded by the metallic bonding due to the melting of the solder particle.

In the case that the solder particle forms the agglomerate of multiple solder particles, the size of the agglomerate may be made same as the aforementioned average particle size of the solder particle. The size of the aggregate may be obtained by observation with an electron microscope or with an optical microscope.

It is noted that the average particle diameter here is the average value of the long axis diameter of the particles measured, for example, at N = 20 or more, preferably N = 50 or more, more preferably N = 200 or more, in an observed image using a metallurgical microscope, an optical microscope, an electron microscope such as a scanning electron microscope (SEM), or the like; when the particle is spherical, it is the average value of the particle diameters. The value may be the measured value obtained by measuring the observed image using known image analysis software ("WinROOF" manufactured by Mitani Corporation; **"A** Zokun (registered trademark)" manufactured by Asahi Kasei Engineering Corporation, etc.), or the measured value obtained by measurement using an image-type particle size distribution measurement device (for example, FPIA-3000 (manufactured by Malvern Instruments Ltd.)) (N = 1000 or more). The average particle diameter obtained from the observed image or by using the image-type particle size analyzers may be regarded as the average value of the maximum length of the particles. When preparing the conductive particle-containing hot melt adhesive sheet 60, the manufacturer's values, such as the particle diameter (D50), which is the cumulative frequency of 50% in the particle size distribution simply obtained by a laser diffraction and scattering method, and the arithmetic mean diameter (preferably on a volume basis) may be used.

The area ratio of the solder particles is preferably, for example, in the range of 8 to 50%, and more preferably in the range of 9.5 to 50%. The area ratio of the solder particles is calculated using the particle size of the solder particles in the conductive particle-containing hot melt adhesive sheet 60 before the attaching step. Specifically, the particle diameter of each of the solder particles contained within each region in a plurality of 1 mm² regions is measured from a microscopic plan view image of the conductive particle-containing hot melt adhesive sheet 60 before the attaching step. Next, the area of each solder particle in the plan view is calculated from the measured particle size, and the area ratio of each area is calculated using the formula "(total calculated solder particle area/1 mm²) × 100". Next, the average of the area ratio of the observed multiple areas is calculated; then, the resulting calculated average value is used as the area ratio of the solder particles contained in the conductive particle-containing hot melt adhesive sheet 60.

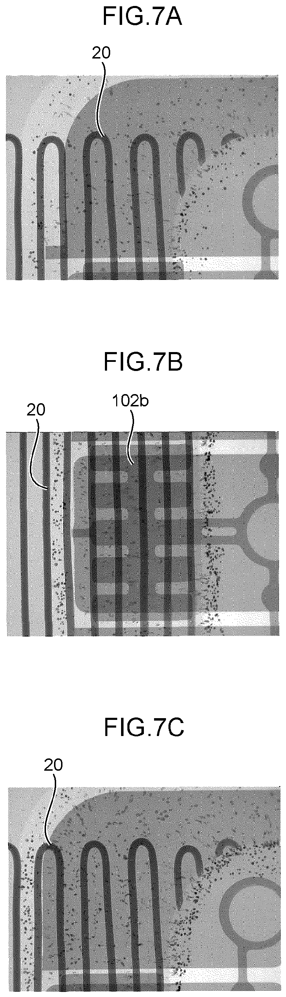

FIG. 7A through 7C are photographs of the hot press-bonded section at the hot press-bonding step described before. FIG. 7A is the photograph of the conductive particle-containing hot melt adhesive sheet 60 with the solder particle's area ratio of 4.5%, in which the hot press-bonding was performed at a temperature where the spring back occurs. As can be seen in FIG. 7A, when the solder particle's area ratio is less than 8%, it is difficult to observe the spring back by the nondestructive inspection using an X-ray due to the small number of the solder particles, making it impossible to judge whether the bonding by the solder particle is good or bad. FIGS. 7B and 7C are photographs of the conductive particle-containing hot melt adhesive sheet 60 with the solder particle's area ratio of 8%, in which the hot press-bonding was performed at a temperature where the spring back occurs. As can be seen in FIG. 7B, it is difficult to observe the spring back in the electrode sections (the first electrode section 102a and the second electrode section 102b) of the IC chip 10 that are electrically connected to the antenna 20 by the solder particle because the solder particles escape, but outside of the electrode sections, it is possible to observe the solder particles, as can be seen in FIG. 7C. For this reason, the lower limit of the solder particle's area ratio is set at 8%. When the solder particle's area ratio is 9.5% or more, melting of the solder particles is visible, so that it is possible to observe the spring back even in the electrode sections. Therefore, the solder particle's area ratio is preferably 9.5% or more.

As for the upper limit of the solder particle's area ratio, when the solder particle's area ratio is more than 50%, the resin content in the binder is reduced, so that the adhesion strength between the IC chip 10 and the base substrate 30 may be insufficient. In the case that the electrode on the base substrate 30 side is bonded using the conductive particle-containing hot melt adhesive sheet 60 as in the case of a fingerprint sensor where the distance between adjacent electrodes is short, when the solder particle's area ratio is more than 50%, the solder particles may cause a short circuit between the adjacent electrodes. For this reason, the upper limit of the solder particle's area ratio is set at 50%.

The viscosity of the conductive particle-containing hot melt adhesive sheet 60 at the solidus temperature of the solder particle is preferably in the range of 1,000 to 100,000 Pa•s.When the viscosity is less than 1,000 Pa•s,bubbles are formed in the conductive particle-containing hot melt adhesive sheet 60 during the hot press-bonding, causing the spring back and thereby resulting in poor bonding. When the viscosity is more than 100,000 Pa•s,the flow of the resin and the solder particles in the binder is insufficient, resulting in poor bonding.

### [Other Additives]

In addition to the binder and the solder particle as described above, various additives may be blended into the conductive particle-containing hot melt adhesive sheet 60 to the extent that the advantageous effects of the present invention are not impaired. For example, nano-sized silica (primary particle size of 1 nm or more and less than 1,000 nm) may be dispersed in order to improve a gas barrier property and an elastic modulus. In order to control the height of the solder particle at a certain level after the press-bonding, a resin particle, a rubber particle, a silicone rubber particle, silica, or the like having a specified size may be dispersed as the spacer particle. A thermosetting resin and a curing agent may also be added to the extent that the advantageous effects of this technology are not impaired.

### [Examples]

In the examples below, the conductive particle-containing hot melt adhesive sheet 60 including the solder particle was prepared, and by using the resulting adhesive sheet, the smart card 1 was obtained. Then, the adhesion strength between the IC chip 10 and the base substrate 30 was evaluated, and the bonding between the IC chip 10 and the base substrate 30 was evaluated by the nondestructive testing. Note that the examples are not limited to those described below.

### [Preparation of Solder Particles]

Metal materials at a predetermined mixing ratio were placed in a vessel under heat; and after the resulting mixture was melted, this was cooled to obtain a solder alloy. From the resulting solder alloy, a powder was prepared by an atomization method and classified into the particle size ranging from 20 to 38 µm to obtain the solder particle having the following composition.
- Type4 Sn-40Bi (non-eutectic; solidus temperature of 139°C; liquidus temperature of 167°C)
- Type4 Sn-58Bi (eutectic; solidus and liquidus temperatures of 138°C)

### [Preparation of Conductive Particle-containing Hot Melt Adhesive Sheet]

Following resins and fillers were prepared.
- PES-111EE (crystalline polyester manufactured by ToaGosei Co., Ltd.); dissolved at solid content/cyclohexanone solution = 25/75
- HX2519 (manufactured by Arkema S.A.; crystalline polyamide having a carboxyl group; terminal carboxyl group concentration of 6.56 mg KOH/g)
- B-30 (barium sulfate; manufactured by Sakai Chemical Industry Co., Ltd.), particle size of 0.3 µm

As described in Table 1, the above resins with a predetermined blending amount (parts by mass) in terms of solid content were mixed and stirred to obtain a mixed varnish. Solder particles were then added to the resulting mixed varnish to obtain a conductive particle-containing resin composition. The resulting conductive particle-containing resin composition was applied to a 50 µm-thick PET film such that the average thickness after drying became 40 µm. This was dried at 70°C for 5 minutes and then at 120°C for 5 minutes to obtain a conductive particle-containing hot melt adhesive sheet 60.

### [Preparation of Smart Card]

A base substrate 30, which is the laminate consisting of an overlay 31, a core sheet 32, an inlay 33 provided with an antenna 20, a core sheet 34, and an overlay 35, was prepared as the member material of the smart card 1. In the IC chip area 40 of the base substrate 30, a Cu wire having a diameter of 100 µm is exposed from PVC, which is the base substrate 30. A chip module (10.6 mm x 8.0 mm, plated with gold) for testing was also prepared as the IC chip 10. This chip module is a 6-pin Ni/Au plated Cu module with an approximate thickness of 235 µm, and the thickness of the electrode section that will be bonded to the antenna 20 is 35 µm or less.

The conductive particle-containing hot melt adhesive sheet 60 was laminated to the back surface of the IC chip 10. Then, the IC chip 10 having the conductive particle-containing hot melt adhesive sheet 60 attached thereto was placed on the IC chip area 40; then, the smart card 1 that was hot press-bonded four times under the first condition of 195°C, 2.5 bar, and 0.7 sec. and the smart card 1 that was hot press-bonded four times under the second condition of 220°C, 2.5 bar, and 0.7 sec. were formed.

### [Evaluation of Bonding]

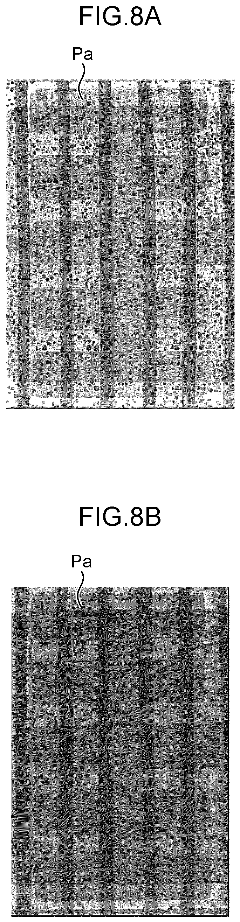

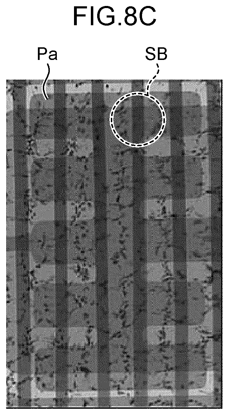

The IC chip area 40 was observed by an X-ray inspection instrument to judge the good/bad of the solder particle's melting; and from the state of the solder particle's melting, the good/bad of the bonding was judged. FIGS. 8A through 8C are the photographs of the hot press-bonded section at the aforementioned hot press-bonding step. In FIGS. 8A through 8C, solder particles Pa are seen as the black dots. In FIG. 8A, the shape of the solder particle Pa is circular, and thereby not observing melting of the solder particle. In FIG. 8C, as seen in the area SB enclosed by the dashed line, it can be seen the state in which a plurality of solder particles Pa are melted along the bubbles generated by the spring back with lining up in a circular pattern while being in the state that a trace of spring back can be seen in the melting of the solder particles Pa. In FIG. 8B, it can be seen that the solder particles Pa have been melted and changed from a circular shape without showing a trace of the spring back. In the evaluation of bonding, "OK" was given to those in which melting of the solder particles was observed as can be seen in FIG. 8B when the hot press-bonding was performed under the first condition described above and a trace of the spring back was observed as can be seen in FIG. 8C when the hot press-bonding was performed under the second condition described above, and "NG" was given otherwise.

### [Evaluation of Adhesion Strength]

The adhesion between the IC chip 10 and the inlay 33 was measured by the TM-423 test specified in the Card Quality Management (CQM) that is a standard of MasterCard (registered trademark), in which the force required to push the IC chip 10 out of the base substrate 30 was measured by applying the force to the back surface of the IC chip 10. Specifically, a hole is drilled from the back surface side of the base substrate 30 toward the IC chip area 40; and a force is applied to the back surface of the IC chip 10 at a speed of 30 mm/min by a 5 mm diameter probe inserted into the drilled hole. The force of less than 100 N when the IC chip 10 was dislodged from the inlay 33 by the probe was considered "NG", and the force of 100 N or more was considered "OK".

Table 1 summarizes the formulation, the bonding evaluation results, and the adhesion strength evaluation results of the conductive particle-containing hot melt adhesive sheet 60 in the first example 1 through the fourth example and the first comparative example through the third comparative example.

### [Table 1]

**Table 1**

| | First Example | Second Example | Third Example | Fourth Example | First Comparative Example | Second Comparative Example | Third Comparative Example |
|---|---|---|---|---|---|---|---|
| Crystalline polyester PES-111EE | 100 | 100 | 100 | 100 | 100 | 100 | 100 |
| Crystalline polyamide HX2519 | 100 | 100 | 100 | 100 | 100 | 100 | 100 |
| Barium sulfate B-30 | - | - | - | 210 | - | - | 240 |
| Sn40Bi (non-eutectic) | 68 | - | 468 | 468 | 58 | 520 | 468 |
| Sn58Bi (eutectic) | - | 68 | - | - | - | - | - |
| Solder particle's area ratio (%) | 8.0 | 8.0 | 50 | 35 | 7.0 | 55 | 32.2 |
| Melt viscosity of resin only at solidus temperature (138°C) of Sn58Bi (Pa·s) | 3000 | 3000 | 3000 | 90000 | 3000 | 3000 | 105000 |
| Bonding evaluation | OK | OK | OK | OK | NG | OK | NG |
| Adhesion strength evaluation | OK | OK | OK | OK | OK | NG | NG |

In the first comparison example, in which the solder particle's area ratio was 7.0%, the spring back was not observed in the bonding evaluation. In the second comparison example, in which the solder particle's area ratio was 55%, an excellent adhesion strength was not obtained in the adhesion strength evaluation because the force at which the IC chip 10 was dislodged from the inlay 33 by the probe was less than 100N. This is believed to be due to the low adhesion strength resulting from the low resin content. In the third comparison example, in which the viscosity of the resin was 105,000 Pa•s,the solder particles and the resin did not flow sufficiently well due to the high viscosity of the resin, resulting in "NG" in both the bonding evaluation and the adhesion strength evaluation.

On the other hand, in the first to fourth examples, in which the solder particle's area ratio was in the range of 8 to 50% and the viscosity was in the range of 1,000 to 100,000 Pa•s,melting of the solder particles was observed in the first condition, a trace of the spring back was observed in the second condition, and excellent results were also obtained in the adhesion strength. In the first example, under the first condition, the resin also flowed and the melting of the solder particles was recognized, and under the second condition, the location of the bubbles were identified by the solder particles that were arranged in a circle due to a sufficient particle density. In the first example, the bonding force exceeded 100 N under both the first and second conditions. In the second example that used the eutectic solder as the solder particle, both the bonding evaluation and the adhesion strength evaluation were good, as in the case of the first example. In the third example, the non-eutectic solder particle's area ratio was increased to 50%; here, both the bonding evaluation and the adhesion strength evaluation were good, as in the case of the first example. In the fourth example, the viscosity was adjusted by adding barium sulfate to the third example to bring the viscosity to 90,000 Pa·s; both the bonding evaluation and adhesion strength evaluation were good, as in the case of the first example.

### Reference Signs List

- 1: Smart Card
- 10: IC chip
- 20: Antenna
- 21a: First exposed section
- 21b: Second exposed section
- 30: Base substrate
- 60: Conductive particle-containing hot melt adhesive sheet
- 102a: First electrode section
- 102b: Second electrode section

## Claims

1. An anisotropic conductive film comprising:
a solder particle that is a non-eutectic alloy or an eutectic alloy; and
a thermoplastic resin, wherein
an area ratio of the solder particle is 8 to 50%, and a viscosity of the solder particle at a solidus temperature is 1,000 to 100,000 Pa•s.

2. A method for producing an electronic component, the method comprising:
interposing an anisotropic conductive film that comprises a solder particle that is a non-eutectic alloy or an eutectic alloy, and a thermoplastic resin, has an area ratio of the solder particle of 8 to 50%, and has a viscosity of the solder particle at a solidus temperature of 1,000 to 100,000 Pa•s between an opaque first electronic component and an opaque second electronic component; and
bonding the first electronic component and the second electronic component by hot press-bonding.

3. The method for producing an electronic component according to claim 2, wherein the electronic component is a dual interface card.

4. The method for producing an electronic component according to claim **2,** wherein the first electronic component is a biometric sensor.

5. A card laminate, comprising:
a first electronic component;
a second electronic component;
a base substrate having the second electronic component disposed; and
an anisotropic conductive film that comprises a solder particle that is a non-eutectic alloy or an eutectic alloy, and a thermoplastic resin, has an area ratio of the solder particle of 8 to 50%, and has a viscosity of the solder particle at a solidus temperature of 1,000 to 100,000 Pa•s, wherein
the first electronic component and the second electronic component are bonded by the anisotropic conductive film.

6. The card laminate according to claim 5, wherein the first electronic component is a biometric sensor.
